# EUROPÄISCHE PATENTSCHRIFT

(11) **EP 0 379 907 B1**
(45) Veröffentlichungstag und Bekanntmachung des Hinweises auf die Patenterteilung: **26.10.1994**
(21) Anmeldenummer: 90100589.2
(22) Anmeldetag: 12.01.1990
(51) Int. Cl.: G03F 7/075

(54) **Vorsensibilisierte Druckplatte für den wasserlosen Flachdruck**
Presensitized printing plate for dry lithography
Plaque d'impression présensibilisée pour lithographie à sec

(30) Priorität: 21.01.1989 DE 3901799
(43) Veröffentlichungstag der Anmeldung: 01.08.1990
(73) Patentinhaber: HOECHST AKTIENGESELLSCHAFT, 65926 Frankfurt am Main (DE)
(72) Erfinder: Herrmann, Heinz, Dr., D-6200 Wiesbaden (DE)

(56) Entgegenhaltungen:
- EP-A- 0 137 452
- DD-A- 225 670
- DE-A- 3 811 832
- FR-A- 2 209 122

## Beschreibung

Die Erfindung betrifft eine vorsensibilisierte Druckplatte für den wasserlosen Flachdruck, insbesondere Offsetdruck. Die erfindungsgemäße Druckplatte weist einen Schichtträger, eine durch Strahlung bzw. Licht härtbare Silikonkautschukschicht und ggf. eine nicht klebrige Deckfolie oder Deckschicht auf.

Druckplatten der vorstehend genannten Gattung sind bekannt. So werden in der DE-A 22 07 495 Flachdruckplatten beschrieben, deren lichtempfindliche Schicht ein Organopolysiloxan mit ungesättigten polymerisierbaren oder vernetzbaren Seitenketten enthält, die durch Belichtung vernetzt werden. Durch Auswaschen mit einem organischen Lösemittel werden die unbelichteten Schichtbereiche entfernt. Die Platte hat den Nachteil, daß die belichteten Schichtbereiche häufig keine ausreichende Farbabweisung zeigen und daß die unbelichtete Schicht klebrig ist. Wenn den Schichten zur Erhöhung der Lichtempfindlichkeit Sensibilisatoren zugesetzt wurden, wie es die DE-A 24 22 428 beschreibt, waren diese häufig mit dem Silikonkautschuk unverträglich.

In der EP-B 88 842 werden deshalb für den gleichen Zweck Polyorganosiloxane eingesetzt, die eingebaute Benzophenonreste enthalten. Diese Verbindungen ergeben Schichten mit besserer Verträglichkeit, deren Lichtempfindlichkeit und Farbabweisung jedoch nicht optimal ist.

In der DD-A 225 670 werden ähnliche Flachdruckplatten beschrieben, die eine lichtvernetzbare Schicht aus Polydialkylsiloxandiolen, Tetraalkoxysilanen und einer Kombination von Photoinitiatoren und Coinitiatoren aufweisen. Als Photoinitiatoren werden Benzophenonverbindungen oder Benzoinether, als Coinitiatoren Oniumverbindungen oder organische Halogenverbindungen, z. B. α-Chlor-tetrafluorpropionsäurereste, eingesetzt. Die Platten erfordern sehr hohe Belichtungszeiten.

Aufgabe der Erfindung war es, eine vorsensibilisierte Druckplatte für den wasserlosen Flachdruck bereitzustellen, die eine hohe Lichtempfindlichkeit bei guter Lagerfähigkeit sowie eine nicht klebrige Oberfläche aufweist und Druckformen mit Nichtbildstellen ergibt, die in Abwesenheit von Feuchtwasser eine hohe und dauerhafte Farbabweisung zeigen.

Erfindungsgemäß wird eine vorsensibilisierte Druckplatte für den wasserlosen Flachdruck mit einem Schichtträger und einer lichthärtbaren Silikonkautschukschicht vorgeschlagen.

Die erfindungsgemäße Druckplatte ist dadurch gekennzeichnet, daß die Silikonkautschukschicht einen bei Raumtemperatur vernetzbaren Zweikomponenten-Silikonkautschuk und eine lichtempfindliche Trihalogenmethylverbindung enthält.

Die in der erfindungsgemäßen Druckplatte enthaltenen Trihalogenmethylverbindungen enthalten als Halogenatome im allgemeinen Chlor- oder Bromatome, vorzugsweise Chloratome. Die Verbindungen sind vorzugsweise nichtflüchtig und enthalten bevorzugt mindestens zwei Trihalogenmethylgruppen, die an einen aromatischen oder heterocyclischen Ring gebunden sind. Besonders bevorzugt werden Mono- oder Bis-trichlormethyl-s-triazine, die einen weiteren Substituenten, vorzugsweise einen aromatischen Substituenten enthalten.

Geeignete Trihalogenmethylverbindungen sind in den US-A 3 779 778, 3 954 475, 4 239 850, den DE-A 2 718 259, 2 934 758 und den EP-A 135 863 und 137 452 beschrieben. Bevorzugt werden die 2-Aryl-4,6-bis-trichlormethyl-s-triazine, insbesondere die in der EP-A 137 452 beschriebenen Verbindungen.

Beispiele für solche Verbindungen sind 1-Ethyl-2-(p-trichlormethyl-benzoylmethylen)-benzthiazolin, 1-Methyl-2-(3,5-bis-trichlormethyl-benzoylmethylen)-benzthiazolin, 1,3,3-Trimethyl-2-(3-trichlormethylbenzoylmethylen)indolin, 2-Styryl-, 2-Naphth-1-yl-, 2-Naphth-2-yl-, 2-(4-Ethoxy-naphth-1-yl)-, 2-Phenanthr-9-yl-, 2-Acenaphth-5-yl-, 2-Biphenyl-4-yl-, 2-(4-Styryl-phenyl)-, 2-[4-(3,4-Dimethoxy-styryl)-phenyl]-, 2-(4-p-Chlorstyryl-phenyl)- und 2-(2-Styryl-phenyl)-4,6-bis-trichlormethyl-s-triazin.

Die Trihalogenmethylverbindung wird gewöhnlich in einer Menge von 0,1 bis 30, vorzugsweise 1 bis 10 Gew.-%, bezogen auf die Menge des Zweikomponenten-Silikonkautschuks zugesetzt.

Als Silikonkautschuk soll im Rahmen dieser Erfindung entsprechend der Definition von Noll, "Chemie und Technologie der Silikone", Verlag Chemie, 1968, Seite 332, ein hochmolekulares, im wesentlichen lineares Poly-diorganosiloxan bezeichnet werden, während für die vernetzten bzw. vulkanisierten Produkte die Bezeichnung Silikongummi verwendet wird. Als Silikonkautschuk eignen sich Polydialkylsiloxane mit endständigen OH-Gruppen (durch Kondensation vernetzbarer RTV-2-Silikonkautschuk) und Polydialkylsiloxane mit Alkenyl-Gruppen (durch Addition vernetzbarer RTV-2-Silikonkautschuk). Auch die Verwendung von Gemischen beider Typen ist möglich. Vorzugsweise werden Polydimethylsiloxandiole eingesetzt. Bis zu 20 % der Methylgruppen können auch durch andere Alkyl-, Halogenalkyl- oder auch unsubstituierte oder substituierte Phenyl-Gruppen ersetzt sein.

Die eingesetzten Silikonkautschuke werden in Gegenwart der Trihalogenmethylverbindungen bei Bestrahlung mit aktinischem Licht vernetzt, auch in Abwesenheit der üblichen Vernetzungsmittel. Die Vernetzungsreaktion wird jedoch in Gegenwart von Vernetzungshilfsmitteln stark beschleunigt.

Als Hilfsmittel für die Vernetzung eignen sich bestimmte Silikonkautschukvernetzungsmittel auf Silanbasis. Besonders günstig wirken Vinyl-triacetoxy-silan, Tetraethoxy-silan und oligomere Polydialkylsiloxane mit SiH-Gruppen.

Im allgemeinen verwendet man 1 bis 100, vorzugsweise 10 bis 50 Gew.-% Vernetzungshilfsmittel, bezogen auf die Menge des Silikonkautschuks.

Als Lösemittel für die Komponenten der Schicht verwendet man aromatische Kohlenwasserstoffe, Halogenkohlenwasserstoffe und/oder Ester. Die Lösungen können auch begrenzte Mengen anderer organischer Lösemittel enthalten. Die Konzentration der Lösungen richtet sich nach dem Beschichtungsverfahren und der gewünschten Schichtdicke und liegt normalerweise im Bereich von 3 bis 30 Gew.-% Feststoff.

Die Silikonkautschukschicht kann weitere Addditive enthalten. Zur Verbesserung der mechanischen Eigenschaften und zur Verminderung der Klebrigkeit und des Kaltflusses der ungehärteten Kautschukschicht können verstärkende Füllstoffe, z. B. hochdisperse Kieselsäure, und/oder verträgliche Polymere in die Beschichtungslösung eingearbeitet werden. Die Zusätze sollten etwa 30 % der Polysiloxanmenge nicht übersteigen, sonst leidet die Abhäsivität der Silikongummischicht.

Die Schicht kann mit Farbstoffen bzw. Pigmenten, die das aktinische Licht nicht oder nur schwach absorbieren und die von der Entwicklerflüssigkeit nicht ausgewaschen werden, gefärbt sein.

Eine Steigerung der Lichtempfindlichkeit der Schicht gelingt durch Zugabe von 1,3-Diphenyl-isobenzofuran, einer Substanz, die die Inhibierung von Fotopolymerisation durch Sauerstoff auszuschalten vermag (s. C. Decker et al., Photographic Sci. a. Engg. 23, (1979), S. 137). Die Zusatzmenge an Diphenylisobenzofuran beträgt 0,1 bis 10, vorzugsweise 1 bis 4 Gew.-%, bezogen auf die Menge des Silikonkautschuks.

Die Dicke der Silikonschicht ist unkritisch. Die Schicht muß mindestens so stark sein, daß alle Unebenheiten der Trägerfolie überdeckt werden und daß das gehärtete Bild die für den Druckvorgang nötige mechanische Stabilität besitzt. Sie darf nicht so dick sein, daß die Ablösung der unvernetzten Stellen beim Entwickeln schwierig wird und ein unscharfes Bild entsteht. In der Regel liegt das Schichtgewicht bei 1 bis 30 g/m², vorzugsweise bei 2 bis 10 g/m².

Die unbelichtete, ungehärtete Silikonkautschukschicht ist häufig weich und etwas klebrig. Damit die Film vorlagen beim Kopiervorgang nicht verschmutzt werden und damit sich die Vorlagen leicht verschieben lassen, wird die Schicht mit einem nicht klebrigen transparenten Film abgedeckt. Nach einer ersten Methode kann man eine dünne Kunststoff-Folie aufwalzen, z. B. Folien aus Polyethylen oder Polyethylenterephthalat. Die Dicke der Folie muß möglichst gering sein, damit bei der Kontaktbelichtung keine Bildunschärfe entsteht. Gut geeignet sind Folien der Stärke 5 bis 15 µm. Vor der Entwicklung des Bilds wird die im Entwickler unlösliche Folie entfernt.

Bei einer zweiten Methode laminiert man die Silikonkautschukschicht mit einem dünnen nichtklebenden Polymerfilm, der sich auf einer abtrennbaren Trägerfolie befindet. Vor der Belichtung wird die Trägerfolie entfernt. Falls der dünne nichtklebende Polymerfilm im Entwickler löslich ist, wie z. B. Polyamidfilme, muß er vor der Entwicklung nicht entfernt werden. Im Entwickler unlösliche Filme müssen dagegen vorher durch Abziehen oder Ablösen beseitigt werden. Filme aus wasserlöslichen Polymeren, z. B. aus Polyvinylalkohol, können vor der Entwicklung leicht mit Wasser abgewaschen werden. Die Dicke des nichtklebenden Polymerfilms liegt vorteilhaft zwischen 0,5 und 15 µm.

Nach einer weiteren, bevorzugten Methode beschichtet man die Silikonkautschukschicht mit der Lösung eines nichtklebenden Polymeren. Zur Herstellung der Lösung müssen Lösemittel verwendet werden, die die Silikon schicht beim Aufbringen des Überzugs nicht ablösen. In Betracht kommen vor allem einfache C₁ - C₄-Alkanole bzw. deren Mischungen. Sie können geringere Mengen anderer organischer Lösemittel enthalten, sofern das zum Lösen des eingesetzten Polymeren erforderlich ist. Als Polymere eignen sich z. B. Polyamide und Polyvinylpyrrolidone. Damit die Lösungen die abhäsive Silikonkautschukschicht gleichmäßig benetzen, setzt man ihnen vorteilhafterweise etwas Netzmittel zu, z. B. Fluortenside. Vorzugsweise verwendet man nicht klebrige Polymere mit geringer Sauerstoffpermeation. Sauerstoff verzögert die Vernetzung des Polysiloxans beim Belichten. Die Dicke der nichtklebrigen Deckschicht liegt im Bereich von 0,3 bis 10, vorzugsweise bei 0,5 bis 3 µm.

Aus dem lichtempfindlichen Material erhält man eine druckfertige Flachdruckform durch Belichten unter einer Filmvorlage und Entwickeln.

Zur Belichtung eignen sich z. B. Quecksilberlampen, Kohlenbogenlampen, Metallhalogenidlampen, Xenonlampen, Leuchtröhrengeräte, Lasergeräte, Elektronenstrahlröhren und andere bekannte Belichtungsgeräte.

Die Entwicklung, d. h. die Ablösung der ungehärteten Schichtpartien vom Druckplattenträger, kann mit aliphatischen, aromatischen und halogenierten Kohlenwasserstoffen, mit Estern und Ethern erfolgen. Oft ist eine Abmischung mit Ketonen und/oder Alkoholen günstig. Mit Vorteil verwendet man Gemische von aliphatischen Kohlenwasserstoffen mit Alkoholen.

Die Entwickler können Farbstoffe zum Anfärben der freiwerdenden Trägeroberfläche enthalten, z. B. 0,01 bis 0,5 % Kristallviolett.

Zur weiteren Verfestigung der abhäsiven, aus Silikongummi bestehenden Nichtbildstellen kann die Druckform noch nachbelichtet, nacherwärmt oder mit Stoffen, die die Vernetzung des Silikonkautschuks fördern, nachbehandelt werden. Für Schichten, die Polydialkylsiloxandiole enthalten, können zur Nachbehandlung z. B. organische Zinnverbindungen, Farbstoffbasen wie Kristallviolettbase oder basische Stoffe eingesetzt werden. Brauchbare organische Zinnverbindungen sind z. B. Dibutylzinndiacetat, Dibutylzinndilaurat und Dibutyldimethoxyzinn, geeignete basische Zusätze z. B. Harnstoff, Hexamethylentetramin und Amine wie Triethanolamin oder Isophorondiamin. Entwicklung und chemische Nachbehandlung können vorteilhaft auch im selben Arbeitsschritt erfolgen.

Über den Mechanismus der Härtungsreaktion ist nichts bekannt. Es wird vermutet, daß die bei der Photolyse der Trihalogenmethylverbindungen gebildeten freien Radikale oder Protonen eine Vernetzungsreaktion an den funktionellen Gruppen des Silikonkautschuks bewirken.

Die Erfindung wird im einzelnen anhand der nachfolgenden Beispiele erläutert. Gewichtsteile (Gt) und Volumteile (Vt) stehen im Verhältnis von Gramm zu Milliliter. Mengenverhältnisse und Prozentangaben sind, wenn nichts anderes vermerkt ist, in Gewichtseinheiten zu verstehen. Herstellung und Entwicklung der Druckplatten erfolgte bei Gelblicht.

### Beispiel 1

Eine elektrolytisch aufgerauhte und anodisierte Aluminiumfolie wurde mit Hilfe einer Plattenschleuder (125 Umdrehungen je Minute) mit folgender Silikonkautschuklösung beschichtet:
- 84 Gt: Toluol,
- 15 Gt: einer 33 %igen Lösung eines α,ω-Dihydroxypolydimethyl-siloxans in Toluol, Viskosität bei 25 °C = 9.000 - 15.000 mPa·s,
- 1,0 Gt: Vinyltriacetoxysilan,
- 0,2 Gt: 2-(4-Styryl-phenyl)-4,6-bis-trichlormethyl-s-triazin.

Die Platte wurde eine Minute lang im Trockenschrank bei 100 °C getrocknet, eine Stunde liegen gelassen und dann mit folgender Polyamidlösung auf der Plattenschleuder mit 90 Umdrehungen je Minute beschichtet:
- 1 Gt: in Ethanol lösliches Polyamid, Erweichungspunkt 110 - 120 °C, Schmelzviskosität bei 160 °C = 0,35 - 0,50 Pa·s,
- 87 Vt: Isopropanol,
- 10 Vt: Toluol,
- 3 Vt: n-Butanol,
- 0,5 Vt: nichtionogenes Fluortensid (fluorierter Alkylester, 50 % in Ethylacetat).

Die erhaltene Druckplatte wurde in einem 120 Watt-Röhrenbelichtungsgerät unter einer positiven Filmvorlage 40 s belichtet.

Die bildmäßig belichtete Platte wurde 20 s mit einem mit Entwickler befeuchteten Wattebausch überwischt. Als Entwickler diente ein Gemisch aus gleichen Volumteilen Isopropanol und eines aliphatischen Kohlenwasserstoffgemischs, Siedebereich 159 - 179 °C. Nach Trocknung an der Luft wurde die Druckform durch Aufwalzen von Druckfarbe für den wasserlosen Offsetdruck mittels einer Gummiwalze eingefärbt. Es entstand ein scharfes, der Vorlage entsprechendes Bild.

### Beispiele 2 und 3

Beispiel 1 wurde wiederholt, anstelle von 2-(4-Styryl-phenyl)-bis-trichlormethyltriazin wurden aber die folgenden lichtempfindlichen Halogenverbindungen verwendet:

2-(4-Ethoxy-naphth-1-yl)-4,6-bis-trichlormethyl-s-triazin (Beispiel 2) und 2-Acenaphth-5-yl-4,6-bis-trichlormethyl-s-triazin (Beispiel 3). Es wurden ähnliche Ergebnisse erzielt wie in Beispiel 1.

### Beispiel 4

Beispiel 1 wurde wiederholt, anstelle von Vinyltriacetoxysilan aber Tetraethoxysilan verwendet. Das erzielte Ergebnis entsprach dem von Beispiel 1.

### Beispiel 5

Eine Silikonkautschuklösung aus
- 84 Gt: Toluol,
- 15 Gt: der in Beispiel 1 angegebenen Polydimethylsiloxandiol-Lösung,
- 1,5 Gt: Vinyltriacetoxy-silan,
- 0,2 Gt: des in Beispiel 1 angegebenen Triazins,
- 0,15 Gt: 1,3-Diphenyl-isobenzofuran

wurde mit 125 Umdrehungen je Minute auf eine elektrolytisch aufgerauhte und anodisierte Aluminiumplatte geschleudert. Nach 1 Minute Trocknen bei 80 °C wurde die Schicht mit folgender Lösung (bei 90 U/Minute) überschichtet:
- 1,5 Gt: thermoplastisches Polyamid, Erweichungspunkt 105 bis 115 °C,
- 95 Vt: Isopropanol,
- 4 Vt: Toluol,
- 1 Vt: n-Butanol,
- 0,1 Vt: Fluortensid (wie in Beispiel 1).

Die Deckschicht wurde 1 Minute bei 100 °C getrocknet.

Die Belichtung erfolgte innerhalb von 10 s. im 120-Watt-Röhrenbelichtungsgerät. Wie in Beispiel 1 wurde ein gutes Druckbild erhalten.

### Beispiel 6

Die in Beispiel 1 angesetzte Silikonkautschuklösung wurde leicht verändert: Anstelle von 1,0 Gt Vinyltriacetoxy-silan wurden 1,5 Gt eingesetzt. Die Lösung wurde nach den Angaben in Beispiel 1 auf eine Aluminiumplatte aufgebracht. Das Schichtgewicht betrug nach 1 Minute Trocknen bei 100 °C 2,8 g/m².

Auf die Silikonschicht wurde folgende Polyamidlösung bei 90 U/Minute aufgeschleudert:
- 1,5 Gt: des in Beispiel 5 angegebenen Polyamids,
- 95 Vt: Isopropanol,
- 4 Vt: Toluol,
- 1 Vt: n-Butanol,
- 0,1 Vt: anionisches Fluortensid wie in Beispiel 1.

Die Deckschicht hatte nach der Trocknung (1 Minute bei 100 °C) ein Schichtgewicht von 1 g/m².

Zur Herstellung der Druckform wurde die Platte unter einer positiven Film-Testvorlage (Schrift/Linien/60er-Raster-Bild) 60 s mit einer 5 kW-Metallhalogenid-Lampe im Abstand von 120 cm belichtet und dann 2 Minuten mit der Mischung aus 4 Vt aliphatischem Kohlenwasserstoffgemisch, Siedebereich 176 - 188 °C, und 1 Vt Isopropanol entwickelt.

In einer Offsetdruckmaschine, aus der das Feuchtwerk entfernt worden war, nahm die Druckform an den Bildstellen rasch Druckfarbe an und lieferte saubere gute Drucke. Nach 20.000 Abzügen zeigte die Druckform noch keine deutlichen Veränderungen.

### Beispiel 7

Beispiel 1 wurde wiederholt, in die Silikonlösung aber mit Hilfe einer Rührwerkskugelmühle 1 Gt hochdisperser Kieselsäure eingemahlen. Wie in Beispiel 1 wurde eine gute Druckform erhalten.

## Patentansprüche

1. Vorsensibilisierte Druckplatte für den wasserlosen Flachdruck mit einem Schichtträger und einer lichthärtbaren Silikonkautschukschicht, dadurch gekennzeichnet, daß die Silikonkautschukschicht einen bei Raumtemperatur vernetzbaren Zweikomponenten-Silikonkautschuk und eine lichtempfindliche Trichlor- oder Tribrommethylverbindung enthält.

2. Vorsensibilisierte Druckplatte nach Anspruch 1, dadurch gekennzeichnet, daß die Trihalogenmethylverbindung ein 2-substituiertes 4,6-Bis-trihalogenmethyl-s-triazin ist.

3. Vorsensibilisierte Druckplatte nach Anspruch 2, dadurch gekennzeichnet, daß der Substituent in 2-Stellung eine Arylgruppe ist.

4. Vorsensibilisierte Druckplatte nach Anspruch 1, dadurch gekennzeichnet, daß der Silikonkautschuk ein Polydialkylsiloxan mit endständigen Hydroxylgruppen ist.

5. Vorsensibilisierte Druckplatte nach Anspruch 1, dadurch gekennzeichnet, daß die Silikonkautschukschicht ferner ein Vernetzungshilfsmittel enthält.

6. Vorsensibilisierte Druckplatte nach Anspruch 5, dadurch gekennzeichnet, daß das Vernetzungshilfsmittel ein Vinyltriacetoxysilan oder ein Tetraethoxysilan ist.

7. Vorsensibilisierte Druckplatte nach Anspruch 1, dadurch gekennzeichnet, daß sie zusätzlich eine transparente Deckschicht aus einem organischen Polymeren trägt.

8. Vorsensibilisierte Druckplatte nach Anspruch 7, dadurch gekennzeichnet, daß das organische Polymere ein alkohollösliches Polyamid ist.

9. Vorsensibilisierte Druckplatte nach Anspruch 1, dadurch gekennzeichnet, daß die Silikonkautschukschicht ein Schichtgewicht von 1 bis 30 g/m² hat.

10. Vorsensibilisierte Druckplatte nach Anspruch 7, dadurch gekennzeichnet, daß die Deckschicht eine Dicke von 0,3 bis 10 µm hat.

11. Vorsensibilisierte Druckplatte nach Anspruch 1, dadurch gekennzeichnet, daß die Silikonkautschukschicht 0,1 bis 30 Gew.-% lichtempfindliche Trihalogenmethylverbindung enthält.

## Claims

1. A presensitized printing plate for water-free planographic printing comprising a substrate and a light-curable silicone rubber layer, wherein the silicone rubber layer contains a two-component silicone rubber crosslinkable at room temperature and a light-sensitive trichloro- or tribromomethyl compound.

2. A presensitized printing plate as claimed in claim 1, wherein the trihalogenomethyl compound is a 2-substituted 4,6-bis(trihalogenomethyl)-s-triazine.

3. A presensitized printing plate as claimed in claim 2, wherein the substituent in the 2-position is an aryl group.

4. A presensitized printing plate as claimed in claim 1, wherein the silicone rubber is a polydialkylsiloxane having terminal hydroxyl groups.

5. A presensitized printing plate as claimed in claim 1, wherein the silicone rubber layer additionally contains a crosslinking aid.

6. A presensitized printing plate as claimed in claim 5, wherein the crosslinking aid is a vinyltriacetoxysilane or a tetraethoxysilane.

7. A presensitized printing plate as claimed in claim 1, wherein the printing plate additionally carries a transparent top layer comprising an organic polymer.

8. A presensitized printing plate as claimed in claim 7, wherein the organic polymer is an alcohol-soluble polyamide.

9. A presensitized printing plate as claimed in claim 1, wherein the silicone rubber layer has a weight per unit area of 1 to 30 g/m².

10. A presensitized printing plate as claimed in claim 7, wherein the top layer has a thickness of 0.3 to 10 µm.

11. A presensitized printing plate as claimed in claim 1, wherein the silicone rubber layer contains 0.1 to 30 % by weight of a light-sensitive trihalogenomethyl compound.

## Revendications

1. Plaque d'impression présensibilisée pour l'impression à plat à sec, comportant un support de couche et une couche photodurcissable à base de caoutchouc silicone, caractérisée en ce que la couche à base de caoutchouc silicone contient un caoutchouc silicone à deux composants réticulable à la température ambiante et un composé photosensible contenant des groupes trichlorométhyle ou tribromométhyle.

2. Plaque d'impression présensibilisée selon la revendication 1, caractérisée en ce que le composé contenant des groupes trihalogénométhyle est une 4,6-bis-trihalogénométhyltriazine-s substituée en position 2.

3. Plaque d'impression présensibilisée selon la revendication 2, caractérisée en ce que le substituant en position 2 est un groupe aryle.

4. Plaque d'impression présensibilisée selon la revendication 1, caractérisée en ce que le caoutchouc silicone est un polydialkylsiloxane à groupes hydroxy terminaux.

5. Plaque d'impression présensibilisée selon la revendication 1, caractérisée en ce que la couche à base de caoutchouc silicone contient en outre un agent auxiliaire de réticulation.

6. Plaque d'impression présensibilisée selon la revendication 5, caractérisée en ce que l'agent auxiliaire de réticulation est un vinyltriacétoxysilane ou un tétraéthoxysilane.

7. Plaque d'impression présensibilisée selon la revendication 1, caractérisée en ce qu'elle porte en outre une couche transparente de recouvrement à base d'un polymère organique.

8. Plaque d'impression présensibilisée selon la revendication 7, caractérisée en ce que le polymère organique est un polyamide soluble dans l'alcool.

9. Plaque d'impression présensibilisée selon la revendication 1, caractérisée en ce que la couche à base de caoutchouc silicone a un poids de couche de 1 à 30 g/m².

10. Plaque d'impression présensibilisée selon la revendication 7, caractérisée en ce que la couche de recouvrement a une épaisseur de 0,3 à 10 µm.

11. Plaque d'impression présensibilisée selon la revendication 1, caractérisée en ce que la couche à base de caoutchouc silicone contient de 0,1 à 30 % en poids de composé photosensible contenant des groupes trihalogénométhyle.
